# EUROPEAN PATENT APPLICATION

(11) **EP 4 818 914 A1**
(43) Date of publication of application: **07.10.2026**
(21) Application number: 26167508.6
(22) Date of filing: 25.03.2026
(51) Int. Cl.: G06F 13/16, G11C 5/04

(54) **SYSTEMS INCLUDING TWO-DIE INTEGRATED CIRCUIT (IC) PACKAGES AND HOMOGENEOUSLY-ORIENTED MEMORY CONNECTORS AND RELATED METHODS**

(30) Priority: 31.03.2025 US 202519096355
(71) Applicant: Microsoft Technology Licensing, LLC, Redmond, WA 98052 (US)
(72) Inventor: LEE, Cliff C., Redmond, 98052 (US); LI, Peng, Redmond, 98052 (US); SHAIK, Gouse Babu, Redmond, 98052 (US); REMAKLUS, Perry Willmann, JR., Redmond, 98052 (US); SHAH, Hima, Redmond, 98052 (US)
(74) Representative: CMS Cameron McKenna Nabarro Olswang LLP

(57) **Abstract**

A two-die integrated circuit (IC) package is coupled to dual in-line memory module (DIMM) connectors. The DIMM connectors are homogeneously-oriented (e.g., in a same direction) but the dies on the IC package are oriented opposite to each other. The DIMM connectors are homogeneously oriented to avoid issues with memory card insertion and to minimize DIMM connector density. Because the DIMM connectors are coupled to both of the dies on the IC package, and the dies are oriented opposite to each other, the sub-channels of the physical interfaces (PHYs) on a second die of the two dies is oriented opposite to the sub-channel interfaces in the DIMM connectors. The second die directs memory transactions of a first sub-channel through a second sub-channel interface driver in the PHY and the other die directs memory transactions of a first sub-channel of the memory through a first sub-channel interface driver in the PHY.

## Description

### Field of the Disclosure

The technology of the disclosure relates, in general, to system memory and more particularly to placement of memory card connectors relative to an integrated circuit (IC) package.

### Background

Performance of a computing system depends, in part, on memory access latency, which further depends on a physical distance between processing circuits and memory circuits of the computing system. To maximize a number of memory circuits in close proximity to the processing circuits, a card or board of a computing system may include memory circuits located on both/opposite sides of the processing circuits. Although technological developments have increased the number of processing circuits in an integrated circuit (IC) or semiconductor die ("die"), the number of memory connections that can fit on the perimeter of a die has not increased to the same degree. One solution for accessing more memory from the processing circuits is to spread the processing power over a pair of closely coupled dies, which can provide up to twice the number of memory connections of a single die. To minimize development costs, the two dies may be twins, or replicas of each other, and configured to operate in a cooperative manner. On a package substrate in a system, the two dies may be positioned in opposite orientations so they can be coupled through die-to-die interfaces located along one edge of each die. However, a consequence of the opposite orientations is that the memory interfaces located along other edges of the dies are oppositely oriented. As a result, on one side of a conventional package substrate, half of the memory connectors are oriented to correspond to the memory interfaces on one of the dies and the other half of the memory connectors are in an opposite orientation, to correspond to the memory interfaces on the other die.

### Summary

Exemplary aspects disclosed herein include systems including two-die integrated circuit (IC) packages and homogeneously-oriented memory connectors. Related methods of accessing homogeneously-oriented memory from a two-die IC package are also disclosed. In an exemplary system including a two-die IC package coupled to dual in-line memory module (DIMM) connectors, the DIMM connectors coupled to both dies in the IC package are oriented in a same direction, even though the dies on the IC package are oppositely oriented, to avoid issues with memory card insertion and to minimize DIMM connector density. The sub-channels of the physical interfaces (PHYs) on one of the dies may be oriented the same as the sub-channel interfaces in the DIMM connectors, but the PHYs on the other die have an opposite orientation. In the exemplary system and IC package, one die directs memory transactions of a first sub-channel of the memory through a first sub-channel interface driver in the PHY and the other die directs memory transactions of a first sub-channel through a second sub-channel interface driver in the PHY.

In one exemplary aspect, a system is disclosed. The system includes a system substrate, an IC package on the system substrate, and a plurality of DIMM connectors each having a same longitudinal orientation in a first direction on the system substrate. The plurality of DIMM connectors includes a plurality of first-side DIMM connectors on a first side of the IC package, and a plurality of second-side DIMM connectors on a second side of the IC package. The IC package includes a first die oriented along a die axis extending in the first direction and a second die oriented opposite to the first die along the die axis.

In another exemplary aspect, a method in a system including an IC package including a first die oriented opposite to a second die of a same design on a package substrate is disclosed. The method includes accessing a first sub-channel interface of a first DIMM connector by a first sub-channel interface driver of a PHY of the first die, accessing a second sub-channel interface of the first DIMM connector by a second sub-channel interface driver of the first PHY of the first die, accessing a first sub-channel interface of a second DIMM connector by a second sub-channel interface driver of a first PHY of the second die, and accessing a second sub-channel interface of the second DIMM connector by a first sub-channel interface driver of the first PHY of the second die.

In another exemplary aspect, an IC package is disclosed. The IC package includes a package substrate, a first die having a first orientation on the package substrate along a die axis extending in a first direction, and a second die identical to the first die and having a second orientation on the IC package, opposite to the first orientation along the die axis. Each of the first die and the second die include a first PHY including a first sub-channel interface driver configured to access a first sub-channel interface of a first DIMM connector and a second sub-channel interface driver configured to access a second sub-channel interface of the first DIMM connector. The first sub-channel interface driver of the first PHY in the first die is configured to couple to a first sub-channel interface of a first DIMM connector on a first side of the IC package substrate, and the second sub-channel interface driver of the first PHY on the second die is configured to couple to a first sub-channel interface of a second DIMM connector on a second side of the package substrate.

### Brief Description of the Drawing Figures

The accompanying drawing figures incorporated in and forming a part of this specification illustrate several aspects of the disclosure and, together with the description, serve to explain the principles of the disclosure.

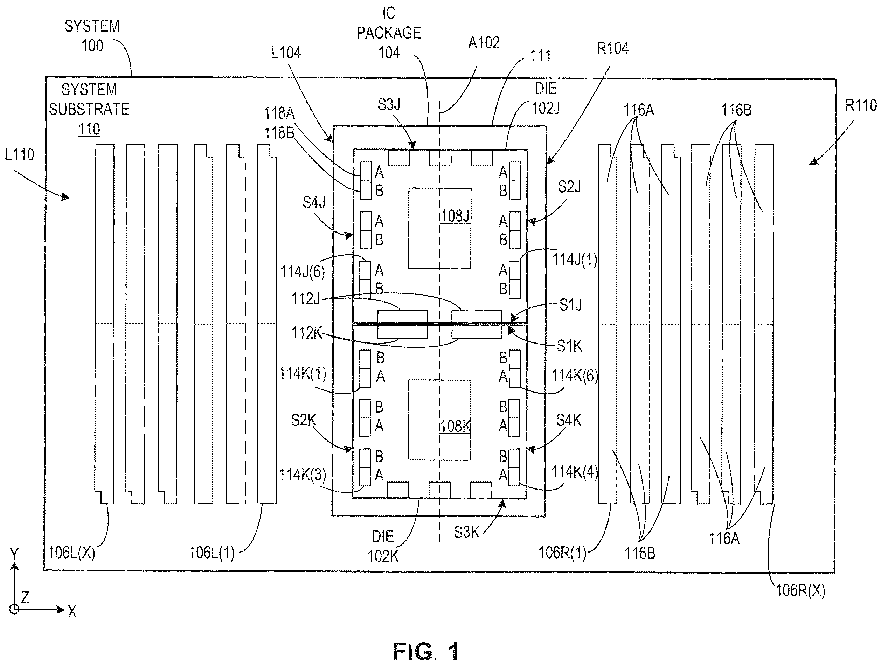

Figure 1 is a plan view of a system including a pair of dies having a same design and oppositely-oriented to each other in an integrated circuit (IC) package and, on either side of the IC package, dual in-line memory module (DIMM) connectors on a system substrate, half of which are oriented to a first one of the dies and half of which are oriented to the other;

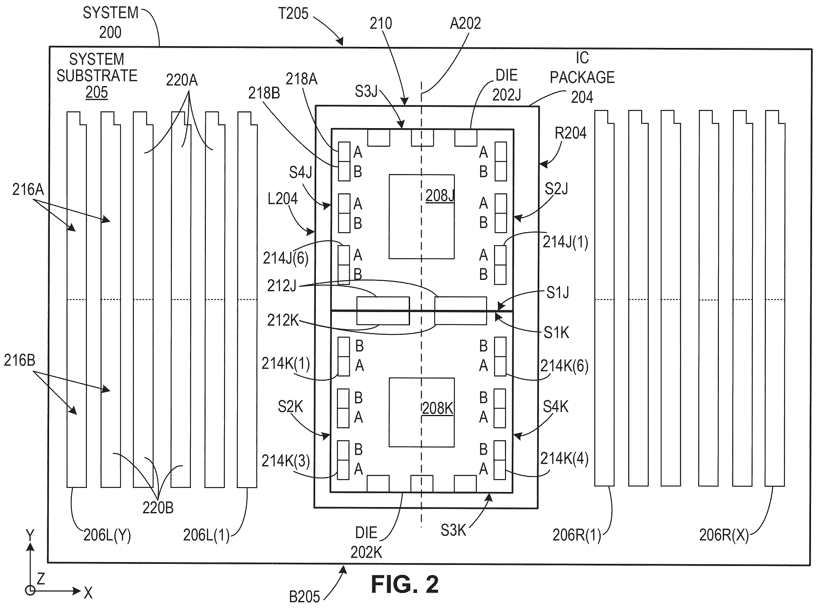

Figure 2 is a plan view of an exemplary system including a pair of dies having a same design and oppositely-oriented to each other in an IC package and, on either side of the IC package, homogeneously-oriented DIMM connectors on a system substrate coupled to the ICs of the IC package;

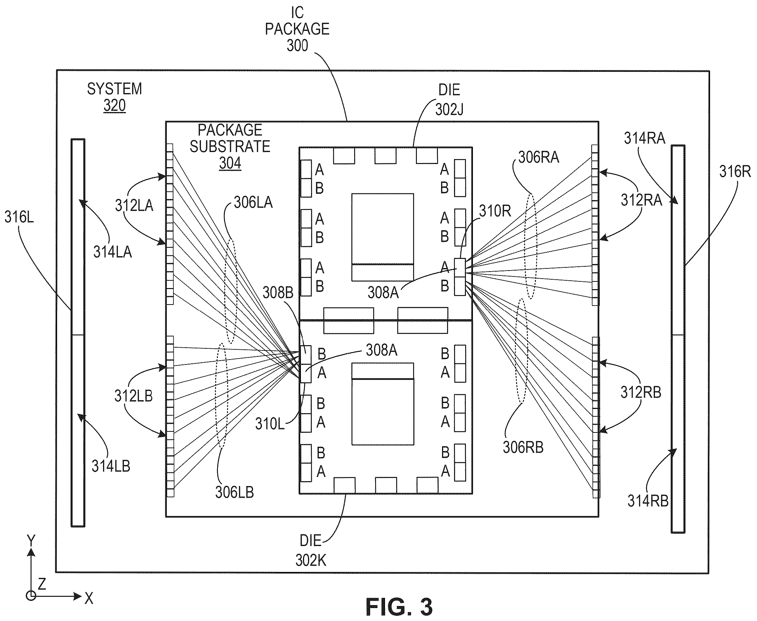

Figure 3 is a plan view of an IC package including a pair of dies having a same design and oppositely-oriented to each other in an IC package, and including an overlapping wiring arrangement so that first sub-channel interface drivers of both ICs are coupled to package connectors for first sub-channel interfaces of homogeneously-oriented DIMM connectors as shown in Figure 2;

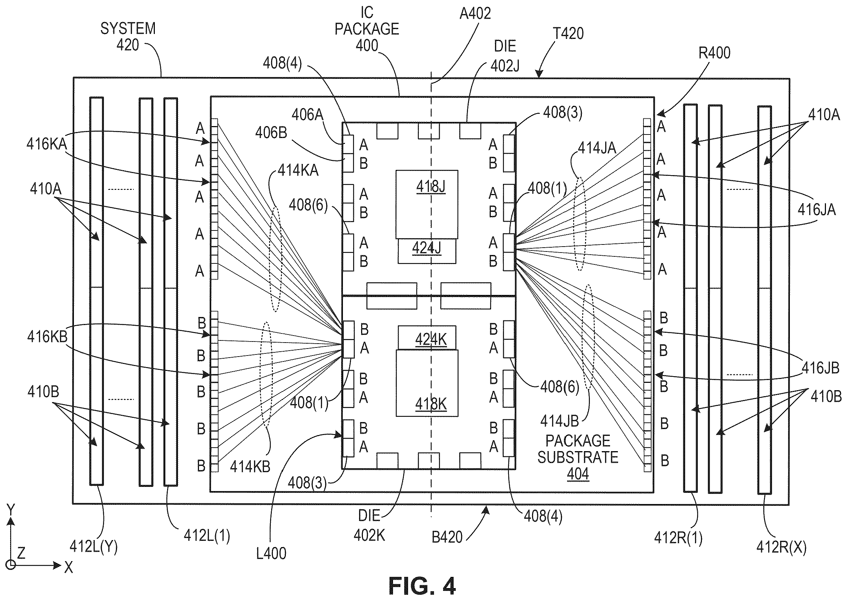

Figure 4 is a plan view of an exemplary IC package including a pair of dies having a same design and oppositely-oriented to each other in an IC package, and including a non-overlapping wiring arrangement in which first sub-channel interface drivers on one die are coupled to package connectors of second sub-channel interfaces of homogeneously-orientated DIMM connectors as shown in Figure 2;

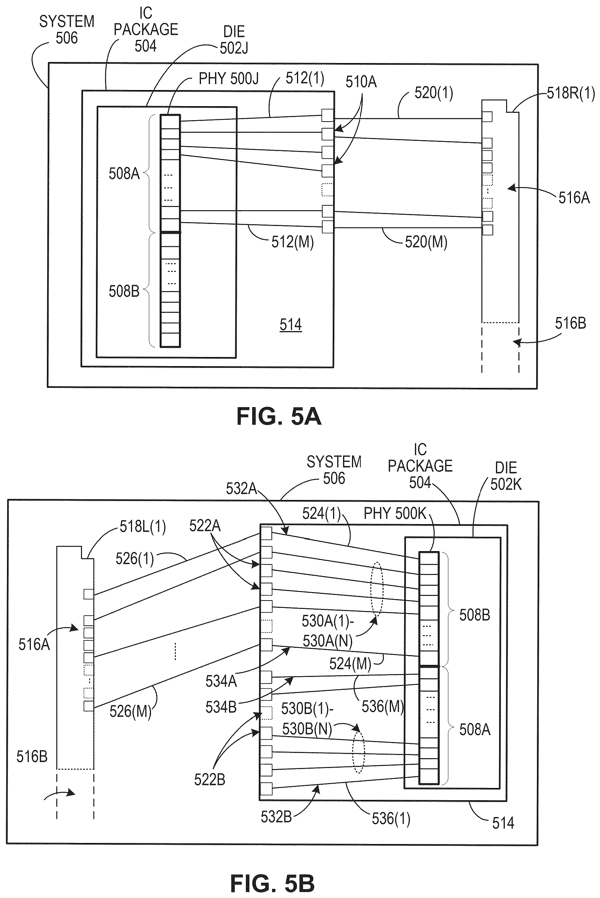

Figure 5A is an illustration of a physical interface on a first die of the pair of dies in Figure 2, including examples of specific signals of a first sub-channel interface driver coupled to package connectors on a package substrate and further coupled to a first sub-channel interface of a DIMM connector;
Figure 5B is an illustration of a physical interface on a second die of the pair of dies in Figure 2, including examples of specific signals of a second sub-channel interface driver coupled to package connectors on a package substrate and further coupled to a first sub-channel interface of a DIMM connector;

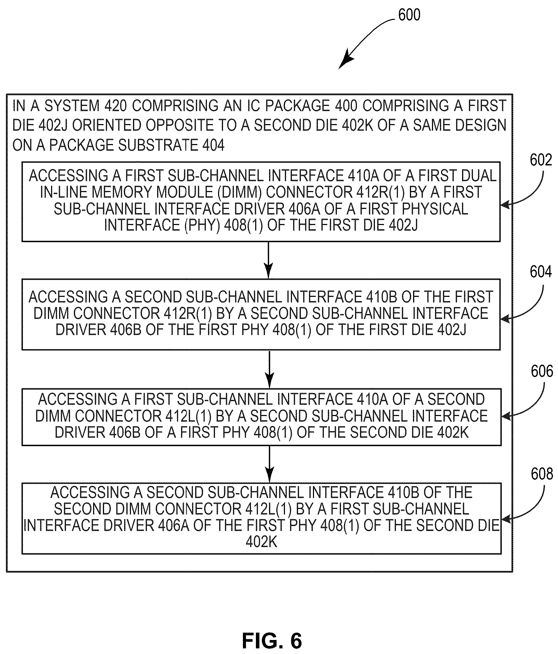

Figure 6 is a flowchart of a method of coupling oppositely-oriented dies of a same design on an IC package to homogeneously-oriented DIMM connectors with non-overlapping wiring on the IC package; and

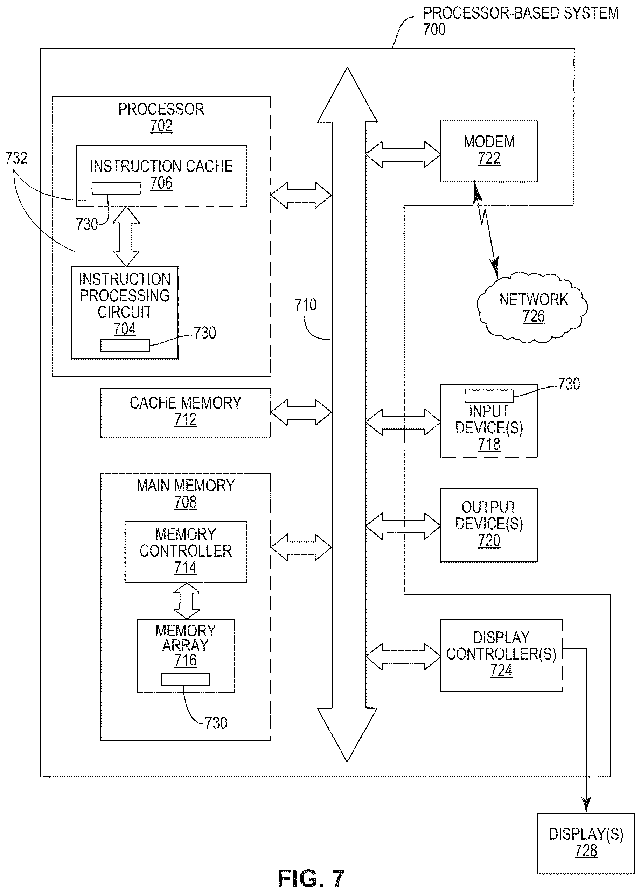

Figure 7 is a block diagram of an exemplary processor-based system that may be included in an IC package including oppositely-oriented dies on a system substrate and homogenously-oriented DIMM connectors on the system substrate on both sides of the IC package.

### Detailed Description

With reference to the drawing figures, several exemplary aspects of the present disclosure are described. The word "exemplary" is used herein to mean "serving as an example, instance, or illustration." Any aspect described herein as "exemplary" is not necessarily to be construed as preferred or advantageous over other aspects.

Exemplary aspects disclosed herein include systems including two-die integrated circuit (IC) packages and homogeneously-oriented memory connectors. Related methods of accessing homogeneously-oriented memory from a two-die IC package are also disclosed. In an exemplary system including a two-die IC package coupled to dual in-line memory module (DIMM) connectors, the DIMM connectors coupled to both dies in the IC package are oriented in a same direction, even though the dies on the IC package are oppositely oriented, to avoid issues with memory card insertion and to minimize DIMM connector density. The sub-channels of the physical interfaces (PHYs) on one of the dies may be oriented the same as the sub-channel interfaces in the DIMM connectors, but the PHYs on the other die have an opposite orientation. In the exemplary system and IC package, one die directs memory transactions of a first sub-channel of the memory through a first sub-channel interface driver in the PHY and the other die directs memory transactions of a first sub-channel through a second sub-channel interface driver in the PHY.

Figure 1 is a plan view of a system 100 including two dies 102J and 102K that have a same design and are oppositely oriented in an IC package 104 on a system substrate 110. Herein, the term "dies" may be used interchangeably with "integrated circuits" (ICs). The system 100 includes dual in-line memory module (DIMM) connectors 106L(1)-106L(X) and 106R(1)-106R(X) (where X=6 in this example) on the system substrate 110. Memory cards (DIMMs, not shown) may be inserted into each of the DIMM connectors 106L(1)-106L(6) and 106R(1)-106R(6) where they may be accessed by processing circuits 108J and 108K, respectively, in the dies 102J and 102K. The dies 102J and 102K may be replicas, duplicates, or twin semiconductor dies having a same hardware circuit design (e.g., having a same part number). Employing two dies of a same design may provide a less expensive solution than developing two dies having different designs. The dies 102J and 102K are described as "oppositely oriented", because the first die 102J is positioned in a first orientation on a package substrate 111 along a die axis A102 extending in a first, Y-axis direction in Figure 1 and the second die 102K is positioned on the package substrate 111 adjacent to the first die 102J in an orientation opposite to the first die 102J along the die axis A102.

The dies 102J and 102K have respective edges or sides S1J-S4J and S1K-S4K. The dies 102J and 102K include die-to-die interfaces 112J and 112K, respectively, which may be located along or adjacent to the first edges S1J, S1K of the dies 102J and 102K. The dies 102J and 102K may be positioned with their edges S1J and S1K abutted to each other (e.g., with little or no spacing) or positioned in close proximity to each other on the package substrate 111 to facilitate high-speed communication between the dies 102J and 102K, which may be needed for cooperative processing between the processing circuits 108J and 108K. For access to the memory cards that may be inserted into the DIMM connectors 106L(1)-106L(6) and 106R(1)-106R(6), the die 102J includes physical interfaces (PHYs) 114J(1)-114J(6) adjacent to edges S2J and S4J and the die 102K includes PHYs 114K(1)-114K(6) on corresponding sides S2K and S4K. The number of PHYs on the dies 102J and 102K in Figure 1 is merely exemplary and may be any appropriate number. The processing circuits 108J and 108K may be configured to execute instructions such as memory transactions that are transmitted through the PHYs 114J(1)-114J(6) and 114K(1)-114K(6) to the DIMM connectors 106L(1)-106L(X) and 106R(1)-106R(X).

The DIMM connectors 106R(1)-106R(6) and 106L(1)-106L(6) may be designed to accept memory cards that have two separately accessible regions of memory, referred to herein as "sub-channel A" and "sub-channel B". Accordingly, each of the DIMM connectors 106R(1)-106R(6) and 106L(1)-106L(6) includes a sub-channel interface 116A to couple to the sub-channel A of the corresponding memory card and a sub-channel interface 116B to couple to the sub-channel B of the memory card. In this regard, each of the PHYs 114J(1)-114J(6) and 114K(1)-114K(6) include sub-channel interface drivers 118A and 118B (labeled as "A" and "B" in Figure 1) to couple to the sub-channel interfaces 116A and 116B of a corresponding one of the DIMM connectors 106R(1)-106R(6) and 106L(1)-106L(6). In some examples, the sub-channel interface drivers 118A and 118B of each of the PHYs 114J(1)-114J(6) and 114K(1)-114K(6) may couple to the sub-channel interfaces 116A and 116B of more than one of the DIMM connectors 106R(1)-106R(6) and 106L(1)-106L(6).

With the side S1J of the die 102J positioned adjacent to the side S1K of the die 102K for low latency communication, the dies 102J and 102K are oriented opposite to each other along the die axis A102. Thus, the PHYs 114J(1)-114J(3) on the side S2J of the die 102J are coupled to DIMM connectors 106R(1)-106R(3) on the first, right side R110 of the system substrate 110 and PHYs 114J(4)-114J(6) on the side S4J of the die 102J are coupled to the DIMM connectors 106L(1)-106L(3) on the second, left side L110 of the system substrate 110. The PHYs 114K(1)-114K(3) on the side S2K of the die 102K are coupled to the DIMM connectors 106L(4)-106L(6) on the second, left side L104 of the IC package 104 and PHYs 114K(4)-114K(6) on the side S4K of the die 102K are coupled to the DIMM connectors 106R(4)-106R(6) on the first, right side R104 of the IC package 104.

Due to the opposite orientations of the dies 102J and 102K, the PHYs 114K(1)-114K(6) are in an opposite orientation to the PHYs 114J(1)-114J(6), which causes the sub-channel interface drivers 118A and 118B of the PHYs 114K(1)-114K(6) to be in an opposite orientation to the sub-channel interface drivers 118A and 118B of the PHYs 114J(1)-114J(6). To orient the sub-channel interfaces 116A and 116B of the DIMM connectors 106R(4)-106R(6) and 106L(4)-106L(6) to correspond to the orientation of the sub-channel interface drivers 118A and 118B in the die 102K, the DIMM connectors 106R(4)-106R(6) are positioned opposite in orientation to the DIMM connectors 106R(1)-106R(3), and the DIMM connectors 106L(4)-106L(6) are positioned opposite in orientation to the DIMM connectors 106L(1)-106L(3). Stated differently, all of the DIMM connectors 106R(1)-106R(6) and 106L(1)-106L(6) are longitudinally oriented in the first, Y-axis direction but the DIMM connectors 106R(4)-106R(6) and 106L(4)-106L(6) are in a reversed or opposite orientation relative to the DIMM connectors 106R(1)-106R(3) and 106L(1)-106L(3).

Having some (in this case half) of the DIMM connectors 106R(1)-106R(6) and 106L(1)-106L(6) oriented opposite to the others can cause installation and handling issues. For example, caution must be exercised to ensure that memory cards inserted into the DIMM connectors 106R(1)-106R(6) and 106L(1)-106L(6) are properly oriented. In addition, different orientations of the DIMM connectors 106R(1)-106R(6) and 106L(1)-106L(6) may prevent optimal relative positioning on the system substrate 110, which may increase the area of the system substrate 110.

Figure 2 is a plan view of an exemplary system 200 including dies 202J and 202K having a same design and oppositely oriented in an IC package 204. The system 200 includes homogeneously-oriented DIMM connectors 206R(1)-206R(X) and 206L(1)-206L(Y) (where X=6 and Y=6 in this example) on a system substrate 205. Having a same design means, in this context, that the dies 202J and 202K may be duplicates, twins, or replicas of each other and may have a same part number. The DIMM connectors 206R(1)-206R(6) may be referred to as first-side DIMM connectors 206R(1)-206R(6) because they are located on a first, right side R204, in the X-axis direction, of the IC package 204 in the example in Figure 2 and the DIMM connectors 206L(1)-206L(6) may be referred to as second-side DIMM connectors 206R(1)-206R(6) because they are located are on a second, left side L204 of the IC package 204.

As noted, the dies 202J and 202K (also referred to as "first die 202J and second die 202K") have a same hardware design, including respective processing circuits 208J and 208K, and are positioned in opposite orientations along a die axis A202 on a package substrate 210. The first die 202J and the second die 202K have edges or sides designated as S1J-S4J and S1K-S4K, respectively, in Figure 2. The first and second dies 202J and 202K include die-to-die interfaces 212J and 212K disposed along or adjacent to the respective edges S1J and S1K. The die-to-die interfaces 212J and 212K may be used for low-latency die-to-die communication, such as for cooperative processing.

The die 202J includes PHYs 214J(1)-214J(6) for transferring signals between the first die 202J and the DIMM connectors 206R(1)-206R(3) and 206L(1)-206L(3). The PHYs 214J(1)-214J(3) are located adjacent to edge S2J and the PHYs 214J(4)-214J(6) are located along or adjacent to edge S4J. The second die 202K includes PHYs 214K(1)-214K(3) located adjacent to edge S2K and PHYs 214K(4)-214K(6) are located adjacent to edge S4K. The number of PHYs on the dies 202J and 202K in Figure 2 is merely exemplary and may be any number to correspond to the DIMM connectors 206R(1)-206R(X) and 206L(1)-206L(Y). Additionally, the connections shown in the example in Figure 2 are merely one option. For example, to provide a more uniform average latency, the PHYs 214J(1)-214J(3) on the first die 202J may be coupled to the DIMM connectors 206R(1), 206R(3), and 206R(5), and the PHYs 214J(4)-214J(6) may be coupled to the DIMM connectors 206L(2), 206L(4), and 206L(6). In such example, the PHYs 214K(1)-214K(6) on the second die 202K may be coupled to DIMM connectors 206R(2), 206R(4), and 206R(6), 206L(1), 206L(3), and 206L(5), respectively. The description of examples herein is not intended to be limiting, as other arrangements of connections between the dies 202J, 202K and the DIMM connectors 206R(1)-206R(6) and 206L(1)-206L(6) are possible.

The processing circuits 208J and 208K may be configured to execute instructions including memory access transactions that are transmitted through the PHYs 214J(1)-214J(6) and 214K(1)-214K(6) to the DIMM connectors 206L(1)-206L(6) and 206R(1)-206R(6). Each of the DIMM connectors 206R(1)-206R(6) and 206L(1)-206L(6) includes a first sub-channel interface 216A to couple to a first sub-channel A of a corresponding memory card and a second sub-channel interface 216B to couple to a second sub-channel B of the memory card.

To avoid issues with regard to installation of memory cards (e.g., DIMMs), and/or handling that may occur due to the oppositely-oriented DIMM connectors 106R(1)-106R(6) and 106L(1)-106L(6) in the system 100 in Figure 1, and to minimize a size of the system substrate 205, the DIMM connectors 206R(1)-206R(6) and 206L(1)-206L(6) in the system 200 are homogeneously oriented in the first, Y-axis direction. In this context, the term "homogeneously oriented" refers to the DIMM connectors 206R(1)-206R(6) and 206L(1)-206L(6) being positioned in a same longitudinal orientation along the first, Y-axis direction (e.g., parallel to the die axis A202) on the system substrate 205. In each of the DIMM connectors 206R(1)-206R(6) and 206L(1)-206L(6), the first sub-channel interface 216A is in a first section 220A of the DIMM connector closer to a first side T205 of the system substrate 205 than a second sub-channel interface 216B in a second section 220B of the DIMM connector that is closer to a second side B205 of the system substrate 205.

Each of the PHYs 214J(1)-214J(6) and 214K(1)-214K(6) include first and second sub-channel interface drivers 218A and 218B (labeled as "A" and "B" in Figure 2) to couple to the first and second sub-channel interfaces 216A and 216B, respectively. According to the orientation of the first die 202J, the first sub-channel interface driver 218A of a first PHY 214J(1) is closer in the first, Y-axis direction to the first side T205 of the system substrate 205 than the second sub-channel interface driver 218B of the same first PHY. In contrast, in the second die 202K, the first sub-channel interface driver 218A of the first PHY 214K(1) is closer in the first, Y-axis direction to the second side B205 of the system substrate 205 than the second sub-channel interface driver 218B of the first PHY 214K(1). In other words, since the second die 202K is a duplicate or replica of the first die 202J, the first PHY 214K(1) is in a location that corresponds to the first PHY 214J(1) on the first die 202J but, due to the opposite orientation of the first die 202J and the second die 202K, the first and second sub-channel interface drivers 218A and 218B of the first PHY 214K(1) are oriented opposite to the first and second sub-channel interface drivers 218A and 218B of the first PHY 214J(1). In view of the corresponding locations, the first PHY 214J(1) of the die 202J may be referred to as a first die first PHY 214J(1) and the first PHY 214K(1) of the die 202K may be referred to as a second die first PHY 214K(1).

Although the sub-channel interface drivers 218A and 218B in the die 202J are in a same orientation as the sub-channel interfaces 216A and 216B of the DIMM connectors 206R(1)-206R(3) and 206L(1)-206L(3), the sub-channel interface drivers 218A and 218B in the PHYs 214K(1)-214K(6) in die 202K are opposite to the sub-channel interfaces 216A and 216B of the DIMM connectors 206R(4)-206R(6) and 206L(4)-206L(6). Figures 3 and 4 show options for interconnects that may be employed on the IC package 204 to couple the first PHY 214K(1) in the die 202K to one of the DIMM connectors 206L(4)-206L(6).

Figure 3 is a plan view of an example of an IC package 300 that may be employed in a system 320 having homogeneously-oriented DIMM connectors, such as the system 200 in Figure 2. The IC package 300 includes dies 302J and 302K that have a same design but are oppositely oriented on a package substrate 304. The dies 302J and 302K may be the dies 202J and 202K in Figure 2. Figure 3 shows an example of an overlapping wiring arrangement in which interconnects 306RA from a first sub-channel interface driver 308A of a first PHY 310R on a first die 302J are coupled to package connectors 312RA on the package substrate 304. The package connectors 312RA are configured to couple to a first sub-channel interface 314RA of a DIMM connector 316R, which corresponds to one of the DIMM connectors 206R(1)-206R(3) in Figure 2. Interconnects 306LA from a first sub-channel interface driver 308A of a first PHY 310L on a second die 302K are coupled to package connectors 312LA on the package substrate 304. The package connectors 312LA are configured to couple to a first sub-channel interface 314LA of a DIMM connector 316L, which corresponds to one of the DIMM connectors 206L(4)-206L(6) in Figure 2. Also, interconnects 306LB from a second sub-channel interface driver 308B of the PHY 310L are coupled to package connectors 312LB on the package substrate 304, which are configured to couple to a second sub-channel interface 314LB on the DIMM connector 316L. The relative positioning of the package connectors 312LA and 312LB in the first, Y-axis direction, corresponds to an orientation of the sub-channel interfaces of the DIMM connectors 206L(4)-206L(6) in Figure 2.

It should be understood that a sub-channel interface in a DIMM connector, such as the DIMM connectors 316L and 316R, include multiple signal pins (not shown) that provide connections between a memory card inserted into a DIMM connector and interconnects (e.g., a wire) on the system substrate (not shown) (referred to herein as "substrate interconnects"). The substrate interconnects are wires extending across the system substrate and are also coupled to signal pins (not shown) in the package connectors 312LA, 312LB, 312RA, 312RB on the package substrate 304. The interconnects 306LA, 306LB, 306RA, and 306RB on the package substrate 304 are coupled to signal pins in the sub-channel interfaces 308A and 308B on the dies 302J and 302K. In this manner, multiple data bit signals (e.g., 32 data bits, for example), data strobe bit signals, and command/address bit signals, as well as parity bit signals, clock bit signals, chip select bit signals, and signals for other information may be transferred between pins of the PHYs on the dies 302J, 302K and pins of the DIMM connectors. The actual number of signal pins in each of the interconnects 306RA, 306RB, 306LA, and 306LB and corresponding package connectors 312RA, 312RB, 312LA, and 312LB may be significantly more than the number shown in Figure 3, which is merely representative. Other signals between the IC package 300 and the DIMM connectors, such as an "I3C" interface for controlling a registering clock driver (RCD) on a memory card, are not shown. The interconnects 306RA, 306RB, 306LA, and 306LB are arranged as shown in Figure 3 to accommodate the homogeneous orientation of the DIMM connectors shown in Figure 2. Because the interconnects 306LA and interconnects 306LB in Figure 3 are overlapped, or "crisscross" each other, the package substrate 304 may include a high number of metal layers, which may increase both complexity and cost of the IC package 300.

Figure 4 is a plan view of an example of an IC package 400 in a system 420 having DIMM connectors that are in homogeneous longitudinal orientation in a first direction, like the systems 200 and 320 in Figures 2 and 3. The IC package 400 includes dies 402J and 402K that have a same design but are oppositely oriented (rotated 180 degrees with respect to each other in an X-axis, Y-axis plane) on a package substrate 404 and aligned along a die axis A402. The dies 402J and 402K may be the dies 202J and 202K in Figure 2.

The dies 402J and 402K each include PHYs 408(1)-408(6) in which there are sub-channel interface drivers 406A and 406B. A first PHY 408(1) on the first die 402J, also referred to herein as first die first PHY 408(1), is in a same relative position on the first die 402J as a first PHY 408(1) on the second die 402K, which may be referred to herein as a second die first PHY 408(1) because the first die 402J and the second die 402K are duplicates of a same chip design. In this example, the PHYs 408(1)-408(3) in the die 402J couple to a first plurality of DIMM connectors 412R(1)-412R(X) on a first side R400 (in the second, X-axis direction) of the IC package 400 and the PHYs 408(4)-408(6) in the die 402J couple to a first plurality of DIMM connectors 412L(1)-412L(Y) on a second side L400 of the IC package 400. Also in this example, the PHYs 408(1)-408(3) in the die 402K couple to a second plurality of the DIMM connectors 412L(1)-412L(Y) on the second side L400 of the IC package 400 and the PHYs 408(4)-408(6) in the die 402K couple to a second plurality of the DIMM connectors 412R(1)-412R(X) on the first side R400 of the IC package 400.

Due to the rotation of the die 402K relative to the die 402J, the PHYs 408(1)-408(6) in the die 402K are oriented such that first sub-channel interface drivers 406A are closer to a side B420 of the system 420 than the second sub-channel interface drivers 406B. The second sub-channel interface drivers 406B are closer to a side T420 of the system 420. Thus, the sub-channel interface drivers 406A and 406B on the die 402K on the second side L400 of the IC package 400 are oriented opposite to sub-channel interfaces 410A and 410B of the second plurality of DIMM connectors 412L(1)-412L(Y). Despite such opposite orientation, interconnects 414KA and 414KB do not overlap each other, as in Figure 3, because the interconnects 414KA on the package substrate 404 couple the first sub-channel interface driver 406A of PHY 408(1) to package connectors 416KB, and the interconnects 414KB on the package substrate 404 couple the second sub-channel interface driver 406B of the PHY 408(1) on die 402K to package connectors 416KA. Signals transmitted through the pins in the interconnects 414KA, 414KB, 414JA, and 414JB for memory transactions to corresponding sub-channel interfaces include multiple data bit signals (e.g., 32 bits or more), data strobe bit signals, and command/address bit signals, as well as parity signals, clock signals, chip select signals, and other signals. The package connectors 416KB couple to the second sub-channel interfaces 410B of the second plurality of DIMM connectors 412L(1)-412L(3) and the package connectors 416KA couple to the first sub-channel interface 410A of the DIMM connectors 412L(4)-412L(6). The dies 402J and 402K include processing circuits 418J and 418K that may be configured to execute instructions including memory access transactions that are transmitted through the PHYs 408J(1)-408J(6) and 408K(1)-408K(6) to the DIMM connectors 412R(1)-412R(6) and 412L(1)-412L(6).

In the configuration of the IC package 400, memory transactions in the die 402K that are directed to the first sub-channel interfaces 410A of the second plurality of DIMM connectors 412L(1)-412L(Y) on the second side L400 of the package substrate 404 are directed through the second sub-channel interface drivers 406B of the PHYs 408L(1)-408L(3) to accommodate the homogeneous longitudinal orientation of the DIMM connectors 412L(1)-412L(Y) and 412R(1)-412R(X), as also shown in Figure 2, without the need for overlapping the interconnects 414KA and 414KB in the manner shown in Figure 3.

In the die 402J, memory transactions directed to the first sub-channel interfaces 410A of the first plurality of DIMM connectors 412R(1)-412R(X) on a first side R400 of the IC package 400 are directed through the first sub-channel interface drivers 406A (e.g., of PHY 408(1)), and memory transactions directed to the second sub-channel interfaces 410B of the first plurality of DIMM connectors 412R(1)-412R(X) are directed through the second sub-channel interface drivers 406B. Also on the first side R400 of the IC package 400, the second sub-channel interface drivers 406B of the PHYs 408(4)-408(6) of the die 402K couple to the first sub-channel interfaces 410A of the second plurality of DIMM connectors 412R(1)-412R(X) and the first sub-channel interface drivers 406A of the PHYs 408(4)-408(6) couple to the second sub-channel interfaces 410B of the second plurality of DIMM connectors 412R(1)-412R(X).

The IC package 400 in Figure 4 may allow the DIMM connectors 412L(1)-412L(Y) and 412R(1)-412R(X) to be in a homogeneous longitudinal orientation, while avoiding the need for overlapping interconnects and avoiding the previously-known issues associated with insertion of memory cards into DIMM connectors having different orientations. The IC package 400 may also reduce area of the system 420.

The system 420 in Figure 4 includes an exemplary arrangement of the interconnects 414KA and 414KB on the package substrate 404. The dies 402J and 402K include configuration registers 424J and 424K, respectively, for controlling memory transactions. Directing memory transactions to the first sub-channel interfaces 410A through the second sub-channel interface drivers 406B and memory transactions to the second sub-channel interfaces 410B through the first sub-channel interface drivers 406A may include programming configuration registers 424K and/or firmware. For example, addresses of the first sub-channel interfaces 410A may be swapped with addresses of the second sub-channel interfaces 410B, and vice versa, under the control of the configuration registers 424K, by firmware control or a combination of the configuration registers 424K and firmware. Thus, addresses of the first sub-channel interfaces 410A may be sent to the second sub-channel interface drivers 406B and addresses of the second sub-channel interfaces 410B may be sent to the first sub-channel interfaces drivers 406A.

Figures 5A and 5B are illustrations of a PHY in each of two dies that are oppositely oriented on a package substrate in a system, such as the dies 402J and 402K in Figure 4. Figure 5A is an illustration of a first PHY 500J in a first die 502J in an IC package 504 in a system 506. Figure 5A is provided to illustrate examples of signals transmitted through a first sub-channel interface driver 508A of the PHY 500J, which is coupled to package connectors 510A by package interconnects 512(1)-512(M) on a package substrate 514. The package connectors 510A may be the package connectors 416KA, 416KB, 416JA, and 416JB in Figure 4. The package connectors 510A are further coupled to a first sub-channel interface 516A of a DIMM connector 518R(1) by system substrate interconnects 520(1)-520(M). The DIMM connector 518R(1) is one of a plurality of first side DIMM connectors oriented in a same longitudinal direction, as shown in Figures 2 and 4. For example, the system 506 may be the system 200 in Figure 2 or the system 420 in Figure 4 and the DIMM connector 518R(1) may be any of the first plurality of DIMM connectors 412R(1)-412R(X) in Figure 4 or any of the DIMM connectors 206R(1)-206R(X) in Figure 2. The first sub-channel interface driver 508A and the second sub-channel interface driver 508B have a same orientation to each other, in the first direction, as the first sub-channel interface 516A and the second sub-channel interface 516B. Signals transmitted through the package connectors 510A may include data bit signals (e.g., 32 bits or more), data strobe bit signals, and command/address bit signals, as well as parity signals, clock signals, chip select signals, and other bit signals.

Figure 5B is an illustration of the first PHY 500K in a second die 502K in the IC package 504 in the system 506 in Figure 5A. Figure 5B is provided to illustrate examples of signals transmitted through a second sub-channel interface driver 508B of the PHY 500K, which is coupled to package connectors 522A by first interconnects 524(1)-524(M) (e.g., package interconnects 524(1)-524(M)) on the package substrate 514. Since the first die 502J in Figure 5A and the second die 502K in Figure 5B have a same design, the PHY 500K in the second die 502K corresponds to the PHY 500J in the first die 502J (e.g., same relative location on the die).

The package connectors 522A are further coupled to a first sub-channel interface 516A of a DIMM connector 518L(1) by system substrate interconnects 526(1)-526(M). The DIMM connector 518L(1) is one of a plurality of second-side DIMM connectors as shown in Figures 2 and 4. The system 506 may be the system 200 in Figure 2 or the system 420 in Figure 4 and the DIMM connector 518L(1) may be any of the first plurality of DIMM connectors 412L(1)-412L(Y) in Figure 4 or any of the DIMM connectors 206L(1)-206L(Y) in Figure 2. The first sub-channel interface driver 508A and the second sub-channel interface driver 508B of the PHY 500K have an opposite orientation, in the first direction, to the first sub-channel interface 516A and the second sub-channel interface 516B of the DIMM connector 518L(1). The package connectors 522A may include data bit signal pins (e.g., 32 bits or more), data strobe signal pins, and command/address bit signal pins, as well as parity signal pins, clock signal pins, chip select signal pins, and pins for other bits. In this example, first data bits 530A(1)-530A(N), first chip select signal 532A, and first parity signal 534A may be transmitted through first interconnects 524(1)-524(M) to package connectors 522B and second data bits 530B(1)-530B(N), second chip select signal 532B, and second parity signal 534B may be transmitted through second interconnects 536(1)-536(M) to package interconnects 522B.

Thus, the plurality of first interconnects 524(1)-524(M), on the package substrate 514, configured to transfer first data bits 530A(1)-530A(N) and extending from the second sub-channel interface driver 508B of the second die first PHY 500K to package connectors 522A coupled to the first sub-channel interface 516A of a first second-side DIMM connector 518L(1) of the plurality of second-side DIMM connectors 518L(1)-518L(Y) (only 518L(1) is shown in Figure 5B); and a plurality of second interconnects 536(1)-536(M) configured to transfer second data bits 530B(1)-530B(N) and extending from the first sub-channel interface driver 508A of the second die first PHY 500K to package connectors 522B coupled to the second sub-channel interface 516B of the first second-side DIMM connector 518L(1).

The first chip select signal 532A may be transferred on the first interconnects 524(1)-524(M) from the second sub-channel interface driver 508B of the second die first PHY 500K to a first package interconnect 522A coupled to a first sub-channel interface 516A of the first second-side DIMM connector 518L(1), and a second chip select signal 532B may be transferred on the second interconnects 536(1)-536(M) from the first sub-channel interface driver 508A of the second die first PHY 500K to the second sub-channel interface 516B of the first second-side DIMM connector 518L(1).

The first parity signal 534A may be transferred on the first interconnects 524(1)-524(M) from the second sub-channel interface driver 508B of the second die first PHY 500K to a first package interconnect 522A coupled to a first sub-channel interface 516A of the first second-side DIMM connector 518L(1), and a second parity signal 534B may be transferred on the second interconnects 536(1)-536(M) from the first sub-channel interface driver 508A of the second die first PHY 500K to the second sub-channel interface 516B of the first second-side DIMM connector 518L(1).

Figure 6 is a flowchart of a method in a system 420 comprising an IC package 400 comprising a first die 402J oriented opposite to a second die 402K of a same design on a package substrate 404, the method comprising accessing a first sub-channel interface 410A of a first dual in-line memory module (DIMM) connector 412R(1) by a first sub-channel interface driver 406A of a first physical interface (PHY) 408(1) of the first die 402J (block 602); accessing a second sub-channel interface 410B of the first DIMM connector 412R(1) by a second sub-channel interface driver 406B of the first PHY 408(1) of the first die 402J (block 604); accessing a first sub-channel interface 410A of a second DIMM connector 412L(1) by a second sub-channel interface driver 406B of a first PHY 408(1) of the second die 402K (block 606); and accessing a second sub-channel interface 410B of the second DIMM connector 412L(1) by a first sub-channel interface driver 406A of the first PHY 408(1) of the second die 402K (block 608).

Figure 7 is a block diagram of an exemplary processor-based system 700 that includes a processor 702 (e.g., a microprocessor), including an instruction processing circuit 704. The processor-based system 700 may include integrated circuits on an electronic board or card, such as a printed circuit board (PCB), in a server, a personal computer, a desktop computer, a laptop computer, a personal digital assistant (PDA), a computing pad, a mobile device, or any other device, and may represent, for example, a server, or a user's computer. In this example, the processor-based system 700 includes the processor 702. The processor 702 represents one or more general-purpose processing circuits, such as a microprocessor, central processing unit, or the like. More particularly, the processor 702 may be an EDGE instruction set microprocessor or other processor implementing an instruction set that supports explicit consumer naming for communicating produced values resulting from the execution of producer instructions.

The processor 702 is configured to execute instructions for performing the operations and steps discussed herein. In this example, the processor 702 includes an instruction cache 706 for temporary, fast access memory storage of instructions accessible by the instruction processing circuit 704. Fetched or prefetched instructions from a memory, such as a main memory 708, over a system bus 710, are stored in the instruction cache 706. Data may be stored in a cache memory 712 coupled to the system bus 710 for low-latency access by the processor 702. The instruction processing circuit 704 is configured to process instructions fetched into the instruction cache 706 and process the instructions for execution.

The processor 702 and the main memory 708 are coupled to the system bus 710 and can intercouple peripheral devices included in the processor-based system 700. As is well known, the processor 702 communicates with these other devices by exchanging address, control, and data information over the system bus 710. For example, the processor 702 can communicate bus transaction requests to a memory controller 714 in the main memory 708 as an example of a controlled device. Although not illustrated in Figure 7, multiple system buses 710 could be provided, wherein each system bus 710 constitutes a different fabric. In this example, the memory controller 714 is configured to provide memory access requests to a memory array 716 in the main memory 708. The memory array 716 is comprised of an array of storage bit cells for storing data. The main memory 708 may be a read-only memory (ROM), flash memory, dynamic random-access memory (DRAM), such as synchronous DRAM (SDRAM), etc. and/or static memory (e.g., flash memory, SRAM, etc.), as non-limiting examples. The cache memory 712 and/or the main memory 708 may be included in the memory cards inserted in the DIMM connectors 206R(1)-206R(X) and 206L(1)-206L(Y) or the DIMM connectors 412L(1)-412L(Y) and 412R(1)-412R(X).

Other devices can be connected to the system bus 710. As illustrated in Figure 7, these devices can include the main memory 708, one or more input device(s) 718, one or more output device(s) 720, a modem 722, and one or more display controllers 724, as examples. The input device(s) 718 can include any type of input device, including but not limited to input keys, switches, voice processors, etc. The output device(s) 720 can include any type of output device, including but not limited to audio, video, other visual indicators, etc. The modem 722 can be any device configured to allow an exchange of data to and from a network 726. The network 726 can be any type of network, including but not limited to a wired network (e.g., ethernet) or wireless network, a private or public network, a local area network (LAN), a wireless local area network (WLAN), a wide area network (WAN), a BLUETOOTH^{™} network, and the Internet. The modem 722 can be configured to support any type of communications protocol desired. The processor 702 may also be configured to access the display controller(s) 724 over the system bus 710 to control information sent to one or more displays 728. The display(s) 728 can include any type of display, including but not limited to a cathode ray tube (CRT), a liquid crystal display (LCD), a plasma display, etc.

The processor-based system 700 in Figure 7 may include a set of instructions 730 to be executed by the processor 702 for any application desired according to the instructions. The instructions 730 may be stored in the main memory 708, the processor 702, and/or the instruction cache 706 as examples of a non-transitory computer-readable medium 732. The instructions 730 may also reside, completely or at least partially, within the main memory 708 and/or within the processor 702 during their execution. The instructions 730 may further be transmitted or received over the network 726 via the modem 722, such that the network 726 includes the computer-readable medium 732. The instructions 730 may include programming and/or firmware that configures the configuration registers 424K in Figure 4 to cause the memory transactions directed to first sub-channels of a memory card coupled to die 402K to be transmitted through second sub-channel interface drivers of the PHYs on die 402K and memory transactions directed to second sub-channels of memory cards coupled to die 402K to be transmitted through first sub-channel interface drivers of the PHYs on die 402K.

While the computer-readable medium 732 is shown in an exemplary embodiment to be a single medium, the term "computer-readable medium" should be taken to include a single medium or multiple media (e.g., a centralized or distributed database and/or associated caches and servers) that store the one or more sets of instructions. The term "computer-readable medium" shall also be taken to include any medium that is capable of storing, encoding, or carrying a set of instructions for execution by the processing device and that causes the processing device to perform any one or more of the methodologies of the embodiments disclosed herein. The term "computer-readable medium" shall accordingly be taken to include, but not be limited to, solid-state memories, optical medium, and magnetic medium.

The embodiments disclosed herein include various steps. The steps of the embodiments disclosed herein may be formed by hardware components or may be embodied in machine-executable instructions, which may be used to cause a general-purpose or special-purpose processor programmed with the instructions to perform the steps. Alternatively, the steps may be performed by a combination of hardware and software.

The embodiments disclosed herein may be provided as a computer program product or software that may include a machine-readable medium (or a computer-readable medium) having stored thereon instructions, which may be used to program a computer system (or other electronic devices) to perform a process according to the embodiments disclosed herein. A machine-readable medium includes any mechanism for storing or transmitting information in a form readable by a machine (e.g., a computer). For example, a machine-readable medium includes a machine-readable storage medium (e.g., ROM, random access memory ("RAM"), a magnetic disk storage medium, an optical storage medium, flash memory devices, etc.), and the like.

Unless specifically stated otherwise and as apparent from the previous discussion, it is appreciated that throughout the description, discussions utilizing terms such as "processing," "computing," "determining," "displaying," or the like refer to the action and processes of a computer system, or similar electronic computing device, that manipulates and transforms data and memories represented as physical (electronic) quantities within the computer system's registers into other data similarly represented as physical quantities within the computer system memories or registers or other such information storage, transmission, or display devices.

The algorithms and displays presented herein are not inherently related to any particular computer or other apparatus. Various systems may be used with programs in accordance with the teachings herein, or it may prove convenient to construct more specialized apparatuses to perform the required method steps. The required structure for a variety of these systems will appear from the description above. In addition, the embodiments described herein are not described with reference to any particular programming language. It will be appreciated that a variety of programming languages may be used to implement the teachings of the embodiments as described herein.

Those of skill in the art will further appreciate that the various illustrative logical blocks, modules, circuits, and algorithms described in connection with the embodiments disclosed herein may be implemented as electronic hardware, instructions stored in memory or in another computer-readable medium and executed by a processor or other processing device, or combinations of both. Memory disclosed herein may be any type and size of memory and may be configured to store any type of information desired. To clearly illustrate this interchangeability, various illustrative components, blocks, modules, circuits, and steps have been described above generally in terms of their functionality. How such functionality is implemented depends on the particular application, design choices, and/or design constraints imposed on the overall system. Skilled artisans may implement the described functionality in varying ways for each particular application, but such implementation decisions should not be interpreted as causing a departure from the scope of the present embodiments.

The various illustrative logical blocks, modules, and circuits described in connection with the embodiments disclosed herein may be implemented or performed with a processor, a Digital Signal Processor (DSP), an Application Specific Integrated Circuit (ASIC), a Field Programmable Gate Array (FPGA), or other programmable logic device, a discrete gate or transistor logic, discrete hardware components, or any combination thereof designed to perform the functions described herein. Furthermore, a controller may be a processor. A processor may be a microprocessor, but in the alternative, the processor may be any conventional processor, controller, microcontroller, or state machine. A processor may also be implemented as a combination of computing devices (e.g., a combination of a DSP and a microprocessor, a plurality of microprocessors, one or more microprocessors in conjunction with a DSP core, or any other such configuration).

The embodiments disclosed herein may be embodied in hardware and in instructions that are stored in hardware and may reside, for example, in RAM, flash memory, ROM, Electrically Programmable ROM (EPROM), Electrically Erasable Programmable ROM (EEPROM), registers, a hard disk, a removable disk, a CD-ROM, or any other form of computer-readable medium known in the art. An exemplary storage medium is coupled to the processor such that the processor can read information from and write information to the storage medium. In the alternative, the storage medium may be integral to the processor. The processor and the storage medium may reside in an ASIC. The ASIC may reside in a remote station. In the alternative, the processor and the storage medium may reside as discrete components in a remote station, base station, or server.

It is also noted that the operational steps described in any of the exemplary embodiments herein are described to provide examples and discussion. The operations described may be performed in numerous different sequences other than the illustrated sequences. Furthermore, operations described in a single operational step may actually be performed in a number of different steps. Additionally, one or more operational steps discussed in the exemplary embodiments may be combined. Those of skill in the art will also understand that information and signals may be represented using any of a variety of technologies and techniques. For example, data, instructions, commands, information, signals, bits, symbols, and chips that may be referenced throughout the above description may be represented by voltages, currents, electromagnetic waves, magnetic fields, optical fields, or particles, or any combination thereof.

Unless otherwise expressly stated, it is in no way intended that any method set forth herein be construed as requiring that its steps be performed in a specific order. Accordingly, where a method claim does not actually recite an order to be followed by its steps, or it is not otherwise specifically stated in the claims or descriptions that the steps are to be limited to a specific order, it is in no way intended that any particular order be inferred.

In one aspect, there is provided a system comprising: a system substrate; an integrated circuit (IC) package on the system substrate; and a plurality of dual in-line memory module (DIMM) connectors each having a same longitudinal orientation in a first direction on the system substrate, wherein: the plurality of DIMM connectors comprises: a plurality of first-side DIMM connectors on a first side of the IC package; and a plurality of second-side DIMM connectors on a second side of the IC package; and the IC package comprises: a first die oriented along a die axis extending in the first direction; and a second die oriented opposite to the first die along the die axis.

In one embodiment, each DIMM connector of the plurality of DIMM connectors comprises a first sub-channel interface in a first section of the DIMM connecter closer to a first side of the system substrate than a second sub-channel interface in a second section of the DIMM connector that is closer to a second side of the system substrate.

In one embodiment, the first die comprises a first die first physical interface (PHY) adjacent to a first edge of the first die adjacent to the first side of the IC package; the first die first PHY comprises a first sub-channel interface driver and a second sub-channel interface driver; the first sub-channel interface driver of the first die first PHY is closer to the first side of the system substrate than the second sub-channel interface driver of the first die first PHY; the second die comprises a second die first PHY adjacent to a first edge of the second die adjacent to the second side of the IC package; the second die first PHY comprises a first sub-channel interface driver and a second sub-channel interface driver; and the second sub-channel interface driver of the second die first PHY is closer to the first side of the system substrate than the first sub-channel interface driver of the second die first PHY.

In one embodiment, the first sub-channel interface driver of the first die first PHY is coupled to the first sub-channel interface of a first first-side DIMM connector of the plurality of first-side DIMM connectors; and the second sub-channel interface driver of the second die first PHY is coupled to the first sub-channel interface of a first second-side DIMM connector of the plurality of second-side DIMM connectors.

In one embodiment, the second sub-channel interface driver of the first die first PHY is coupled to the second sub-channel interface of the first first-side DIMM connector of the plurality of first-side DIMM connectors; and the first sub-channel interface driver of the second die first PHY is coupled to the second sub-channel interface of the first second-side DIMM connector of the plurality of second-side DIMM connectors.

In one embodiment, the first sub-channel interface driver of the first die first PHY is coupled to the first sub-channel interface of a first first-side DIMM connector of the plurality of first-side DIMM connectors; and the second sub-channel interface driver of the second die first PHY is coupled to the first sub-channel interface of a second first-side DIMM connector of the plurality of first-side DIMM connectors.

In one embodiment, the first die comprises a first die second PHY on a second edge of the first die adjacent to the second side of the IC package; the first die second PHY comprises a first sub-channel interface driver and a second sub-channel interface driver; the first sub-channel interface driver of the first die second PHY is closer to the first side of the system substrate than the second sub-channel interface driver of the first die second PHY; the second die comprises a second die second PHY on a second edge of the second die adjacent to the first side of the IC package; the second die second PHY comprises a first sub-channel interface driver and a second sub-channel interface driver; the second sub-channel interface driver of the second die second PHY is closer to the first side of the system substrate than the first sub-channel interface driver of the second die second PHY; the first sub-channel interface driver of the first die second PHY is coupled to the first sub-channel interface of a second second-side DIMM connector of the plurality of second-side DIMM connectors; and the second sub-channel interface driver of the second die second PHY is coupled to the first sub-channel interface of a second first-side DIMM connector of the plurality of first-side DIMM connectors.

In one embodiment, the system further comprises: a plurality of first interconnects configured to transfer first data bit signals and extending from the second sub-channel interface driver of the second die first PHY to package connectors coupled to the first sub-channel interface of a first second-side DIMM connector of the plurality of second-side DIMM connectors; and a plurality of second interconnects configured to transfer second data bit signals and extending from the first sub-channel interface driver of the second die first PHY to package connectors coupled to the second sub-channel interface of the first second-side DIMM connector.

In one embodiment, a second chip select signal of the second sub-channel interface driver of the second die first PHY is coupled to a first package connector coupled to the first sub-channel interface of the first second-side DIMM connector; and a first chip select signal of the first sub-channel interface driver of the second die first PHY is coupled to a second package interconnect coupled to the second sub-channel interface of the first second-side DIMM connector.

In one embodiment, a second parity signal of the second sub-channel interface driver of the second die first PHY is coupled to a first parity signal of the first sub-channel interface of the first second-side DIMM connector; and a first parity signal of the first sub-channel interface driver of the second die first PHY is coupled to a second chip select of the second sub-channel interface of the first second-side DIMM connector.

In one embodiment, the first die and the second die each comprise a same hardware circuit design.

In one embodiment, a second orientation of the second die is rotated 180 degrees with respect to a first orientation of the first die.

In one embodiment, each DIMM connector of the plurality of DIMM connectors is configured to couple a double data rate (DDR) memory card to the IC package.

In one embodiment, a first plurality of data pins of the first sub-channel interface of the first die first PHY are coupled to a plurality of data pins of a first sub-channel interface of the first first-side DIMM connector; and a second plurality of data pins of the second sub-channel interface of the second die first PHY are coupled to a second plurality of data pins of a first sub-channel interface of the first second-side DIMM connector.

In another aspect, there is provided a method in a system comprising an integrated circuit (IC) package comprising a first die oriented opposite to a second die of a same design on a package substrate, the method comprising: accessing a first sub-channel interface of a first dual in-line memory module (DIMM) connector by a first sub-channel interface driver of a first physical interface (PHY) of the first die; accessing a second sub-channel interface of the first DIMM connector by a second sub-channel interface driver of the first PHY of the first die; accessing a first sub-channel interface of a second DIMM connector by a second sub-channel interface driver of a first PHY of the second die; and accessing a second sub-channel interface of the second DIMM connector by a first sub-channel interface driver of the first PHY of the second die.

In one embodiment, the method further comprises accessing a first sub-channel interface of a third DIMM connector on the first side of the package substrate by a second sub-channel interface driver of a second PHY of the second die.

In another aspect, there is provided an integrated circuit (IC) package, comprising: a package substrate; a first die having a first orientation on the package substrate along a die axis extending in a first direction; a second die identical to the first die and having a second orientation on the IC package, opposite to the first orientation along the die axis, wherein: each of the first die and the second die comprises a first physical interface (PHY) comprising: a first sub-channel interface driver configured to access a first sub-channel interface of a first dual in-line memory module (DIMM) connector; and a second sub-channel interface driver configured to access a second sub-channel interface of the first DIMM connector; the first sub-channel interface driver of the first PHY in the first die is configured to couple to a first sub-channel interface of a first DIMM connector on a first side of the IC package substrate; and the second sub-channel interface driver of the first PHY on the second die is configured to couple to a first sub-channel interface of a second DIMM connector on a second side of the package substrate.

In one embodiment, the IC package further comprises: a first interconnect extending from a first chip-select signal pin of the first sub-channel interface of the first PHY in the first die to a first package connector on the first side of the package substrate configured to couple to a chip-select signal pin of the first sub-channel interface of the first DIMM connector; and a second interconnect extending from a second chip-select signal pin of the second sub-channel interface of the first PHY in the second die to a second package connector on the second side of the package substrate configured to couple to a chip-select signal pin of the first sub-channel interface of the second DIMM connector.

In one embodiment, the IC package further comprises: a third interconnect extending from a pin for a first parity bit signal in the first sub-channel interface of the first PHY in the first die to a first package connector on the first side of the package substrate configured to couple to a pin for a parity bit signal in the first sub-channel interface of the first DIMM connector; and a fourth interconnect extending from a pin for a second parity bit in the second sub-channel interface of the first PHY in the second die to a second package connector on the second side of the package substrate configured to couple to a pin for a parity bit signal in the first sub-channel interface of the second DIMM connector.

In one embodiment, the IC package further comprises: a first plurality of interconnects extending from data bit signal pins of the first sub-channel interface of the first PHY in the first die to a first plurality of package connectors on the first side of the package substrate configured to couple to a plurality of data bit signal pins of the first sub-channel interface of the first DIMM connector; and a second plurality of interconnects extending from data bit signal pins of the second sub-channel interface of the first PHY in the second die to a second plurality of package connectors on the second side of the package substrate configured to couple to a plurality of data bit signal pins of the first sub-channel interface of the second DIMM connector.

A two-die integrated circuit (IC) package is coupled to dual in-line memory module (DIMM) connectors. The DIMM connectors are homogeneously-oriented (e.g., in a same direction) but the dies on the IC package are oriented opposite to each other. The DIMM connectors are homogeneously oriented to avoid issues with memory card insertion and to minimize DIMM connector density. Because the DIMM connectors are coupled to both of the dies on the IC package, and the dies are oriented opposite to each other, the sub-channels of the physical interfaces (PHYs) on a second die of the two dies is oriented opposite to the sub-channel interfaces in the DIMM connectors. The second die directs memory transactions of a first sub-channel through a second sub-channel interface driver in the PHY and the other die directs memory transactions of a first sub-channel of the memory through a first sub-channel interface driver in the PHY.

It will be apparent to those skilled in the art that various modifications and variations can be made without departing from the spirit or scope of the invention. Since modifications, combinations, sub-combinations, and variations of the disclosed embodiments incorporating the spirit and substance of the invention may occur to persons skilled in the art, the invention should be construed to include everything within the scope of the appended claims and their equivalents.

## Claims

1. A system (100) comprising:
a system substrate (110);
an integrated circuit (IC) package (104) on the system substrate (110); and
a plurality of dual in-line memory module (DIMM) connectors (106R(1)-106R(X), 106L(1)-106L(X)) each having a same longitudinal orientation in a first direction on the system substrate (110),
wherein:
the plurality of DIMM connectors comprises:
a plurality of first-side DIMM connectors (106R(1)-106R(X)) on a first side (R110) of the IC package (104); and
a plurality of second-side DIMM connectors (106L(1)-106L(X)) on a second side (L110) of the IC package (104); and
the IC package (104) comprises:
a first die (102J) oriented along a die axis (A102) extending in the first direction; and
a second die (102K) oriented opposite to the first die along the die axis (A102).

2. The system of claim 1, wherein each DIMM connector of the plurality of DIMM connectors comprises a first sub-channel interface in a first section of the DIMM connecter closer to a first side of the system substrate than a second sub-channel interface in a second section of the DIMM connector that is closer to a second side of the system substrate.

3. The system of claim 2, wherein:
the first die comprises a first die first physical interface (PHY) adjacent to a first edge of the first die adjacent to the first side of the IC package;
the first die first PHY comprises a first sub-channel interface driver and a second sub-channel interface driver;
the first sub-channel interface driver of the first die first PHY is closer to the first side of the system substrate than the second sub-channel interface driver of the first die first PHY;
the second die comprises a second die first PHY adjacent to a first edge of the second die adjacent to the second side of the IC package;
the second die first PHY comprises a first sub-channel interface driver and a second sub-channel interface driver; and
the second sub-channel interface driver of the second die first PHY is closer to the first side of the system substrate than the first sub-channel interface driver of the second die first PHY.

4. The system of claim 3, wherein:
the first sub-channel interface driver of the first die first PHY is coupled to the first sub-channel interface of a first first-side DIMM connector of the plurality of first-side DIMM connectors; and
the second sub-channel interface driver of the second die first PHY is coupled to the first sub-channel interface of a first second-side DIMM connector of the plurality of second-side DIMM connectors.

5. The system of claim 4, wherein:
the second sub-channel interface driver of the first die first PHY is coupled to the second sub-channel interface of the first first-side DIMM connector of the plurality of first-side DIMM connectors; and
the first sub-channel interface driver of the second die first PHY is coupled to the second sub-channel interface of the first second-side DIMM connector of the plurality of second-side DIMM connectors.

6. The system of claim 3, wherein:
the first sub-channel interface driver of the first die first PHY is coupled to the first sub-channel interface of a first first-side DIMM connector of the plurality of first-side DIMM connectors; and
the second sub-channel interface driver of the second die first PHY is coupled to the first sub-channel interface of a second first-side DIMM connector of the plurality of first-side DIMM connectors.

7. The system of claim 3, wherein:
the first die comprises a first die second PHY on a second edge of the first die adjacent to the second side of the IC package;
the first die second PHY comprises a first sub-channel interface driver and a second sub-channel interface driver;
the first sub-channel interface driver of the first die second PHY is closer to the first side of the system substrate than the second sub-channel interface driver of the first die second PHY;
the second die comprises a second die second PHY on a second edge of the second die adjacent to the first side of the IC package;
the second die second PHY comprises a first sub-channel interface driver and a second sub-channel interface driver;
the second sub-channel interface driver of the second die second PHY is closer to the first side of the system substrate than the first sub-channel interface driver of the second die second PHY;
the first sub-channel interface driver of the first die second PHY is coupled to the first sub-channel interface of a second second-side DIMM connector of the plurality of second-side DIMM connectors; and
the second sub-channel interface driver of the second die second PHY is coupled to the first sub-channel interface of a second first-side DIMM connector of the plurality of first-side DIMM connectors.

8. The system of claim 5, further comprising:
a plurality of first interconnects configured to transfer first data bit signals and extending from the second sub-channel interface driver of the second die first PHY to package connectors coupled to the first sub-channel interface of a first second-side DIMM connector of the plurality of second-side DIMM connectors; and
a plurality of second interconnects configured to transfer second data bit signals and extending from the first sub-channel interface driver of the second die first PHY to package connectors coupled to the second sub-channel interface of the first second-side DIMM connector.

9. The system of claim 8, wherein:
a second chip select signal of the second sub-channel interface driver of the second die first PHY is coupled to a first package connector coupled to the first sub-channel interface of the first second-side DIMM connector; and
a first chip select signal of the first sub-channel interface driver of the second die first PHY is coupled to a second package interconnect coupled to the second sub-channel interface of the first second-side DIMM connector,
and/or wherein:
a second parity signal of the second sub-channel interface driver of the second die first PHY is coupled to a first parity signal of the first sub-channel interface of the first second-side DIMM connector; and
a first parity signal of the first sub-channel interface driver of the second die first PHY is coupled to a second chip select of the second sub-channel interface of the first second-side DIMM connector.

10. The system of claim 3, wherein:
a first plurality of data pins of the first sub-channel interface of the first die first PHY are coupled to a plurality of data pins of a first sub-channel interface of the first first-side DIMM connector; and
a second plurality of data pins of the second sub-channel interface of the second die first PHY are coupled to a second plurality of data pins of a first sub-channel interface of the first second-side DIMM connector.

11. A method in a system (100) comprising an integrated circuit (IC) package (104) comprising a first die (102J) oriented opposite to a second die (102K) of a same design on a package substrate (111), the method comprising:
accessing a first sub-channel interface (116A) of a first dual in-line memory module (DIMM) connector (106R(1)) by a first sub-channel interface driver (118A) of a first physical interface (PHY) (114J(1)) of the first die (102J);
accessing a second sub-channel interface (116B) of the first DIMM connector (106R(1) by a second sub-channel interface driver (118B) of the first PHY (114J(1)) of the first die (102J);
accessing a first sub-channel interface (116A) of a second DIMM connector (106L(1)) by a second sub-channel interface driver (118B) of a first PHY (114(K)) of the second die (102K); and
accessing a second sub-channel interface (116B) of the second DIMM connector (106L(1)) by a first sub-channel interface driver (118A) of the first PHY (114K(1) of the second die (102K).

12. The method of claim 11, further comprising:
accessing a first sub-channel interface of a third DIMM connector on the first side of the package substrate by a second sub-channel interface driver of a second PHY of the second die.

13. An integrated circuit (IC) package (104), comprising:
a package substrate (111);
a first die (102J) having a first orientation on the package substrate (111) along a die axis (A102) extending in a first direction;
a second die (102K) identical to the first die (102J) and having a second orientation on the IC package (104), opposite to the first orientation along the die axis (A102),
wherein:
each of the first die (102J) and the second die (102K) comprises a first physical interface (PHY) (114J(1),114K(1)) comprising:
a first sub-channel interface driver (118A) configured to access a first sub-channel interface (116A) of a first dual in-line memory module (DIMM) connector (106R(1)); and
a second sub-channel interface driver (118B) configured to access a second sub-channel interface (116B) of the first DIMM connector (106R(1));
the first sub-channel interface driver (118A) of the first PHY (114J(1)) in the first die (102J) is configured to couple to a first sub-channel interface (116A) of a first DIMM connector (106R(1)) on a first side (R110) of the IC package substrate (111); and
the second sub-channel interface driver (118B) of the first PHY (114K(1)) on the second die (102K) is configured to couple to a first sub-channel interface (116A) of a second DIMM connector (106L(1)) on a second side (L110) of the package substrate (111).

14. The IC package of claim 13, further comprising:
a first interconnect extending from a first chip-select signal pin of the first sub-channel interface of the first PHY in the first die to a first package connector on the first side of the package substrate configured to couple to a chip-select signal pin of the first sub-channel interface of the first DIMM connector; and
a second interconnect extending from a second chip-select signal pin of the second sub-channel interface of the first PHY in the second die to a second package connector on the second side of the package substrate configured to couple to a chip-select signal pin of the first sub-channel interface of the second DIMM connector, or the IC package further comprising:
a first plurality of interconnects extending from data bit signal pins of the first sub-channel interface of the first PHY in the first die to a first plurality of package connectors on the first side of the package substrate configured to couple to a plurality of data bit signal pins of the first sub-channel interface of the first DIMM connector; and
a second plurality of interconnects extending from data bit signal pins of the second sub-channel interface of the first PHY in the second die to a second plurality of package connectors on the second side of the package substrate configured to couple to a plurality of data bit signal pins of the first sub-channel interface of the second DIMM connector.

15. The IC package of claim 13, further comprising:
a third interconnect extending from a pin for a first parity bit signal in the first sub-channel interface of the first PHY in the first die to a first package connector on the first side of the package substrate configured to couple to a pin for a parity bit signal in the first sub-channel interface of the first DIMM connector; and
a fourth interconnect extending from a pin for a second parity bit in the second sub-channel interface of the first PHY in the second die to a second package connector on the second side of the package substrate configured to couple to a pin for a parity bit signal in the first sub-channel interface of the second DIMM connector.
